# EUROPEAN PATENT APPLICATION

(11) **EP 2 444 433 A1**
(43) Date of publication of application: **25.04.2012**
(21) Application number: 10789357.0
(22) Date of filing: 31.05.2010
(51) Int. Cl.: C08G 18/32, B24B 37/00, C08J 5/14, H01L 21/304

(54) **POLYURETHANE, COMPOSITION FOR FORMATION OF POLISHING LAYERS THAT CONTAINS SAME, PAD FOR CHEMICAL MECHANICAL POLISHING, AND CHEMICAL MECHANICAL POLISHING METHOD USING SAME**

(30) Priority: 18.06.2009 JP 2009145239
(71) Applicant: JSR Corporation, Minato-ku Tokyo 105-8640 (JP)
(72) Inventor: OKAMOTO, Takahiro, Tokyo 105-8640 (JP); KUWABARA, Rikimaru, Tokyo 105-8640 (JP)
(74) Representative: TBK
(86) International application number: PCT/JP2010/059184
(87) International publication number: WO 2010/146982

(57) **Abstract**

A polyurethane is produced by reacting a mixture including at least (A) a diisocyanate, (B) a polyol, and (C) a chain extender, the polyol (B) having the number average molecular weight of 400 to 5000, the chain extender (C) including (C1) a compound shown by the following general formula (1) and (C2) a compound shown by the following general formula (2), the compound (C1) and the compound (C2) having a number average molecular weight of less than 400, and a ratio "M₁/(M₁+M₂)" calculated by using the number of moles (M₁) of the compound (C1) and the number of moles (M₂) of the compound (C2) being 0.25 to 0.9.

HO-(CR¹R²)₂ₘ₊₁-OH (1)

HO-(CR³R⁴)₂ₙ-OH (2)

## Description

### TECHNICAL FIELD

The present invention relates to a polyurethane, a polishing layer-forming composition including the same, a chemical mechanical polishing pad, and a chemical mechanical polishing method using the same.

### BACKGROUND ART

A polyurethane elastomer has excellent mechanical characteristics and many advantages (e.g., wear resistance, oil resistance, and bending resistance), and is used as a material for a conveyor belt, a shoe sole, hose, a golf ball, or the like. A porous nonwoven fabric obtained by impregnating nonwoven fabric with a polyurethane solution, a polyurethane molded product, or the like has been used as a polishing pad for polishing glass or a semiconductor substrate (see JP-A-64-58475, for example). As a polishing pad (hereinafter referred to as "chemical mechanical polishing pad") suitable for a chemical mechanical polishing (hereinafter may be referred to as "CMP") method that planarizes the surface of a semiconductor substrate, JP-T-8-500622 discloses a polishing pad wherein a filler-like component is dispersed in a polyurethane, and JP-A-2000-17252 discloses a polishing pad using a urethane foam, for example.

A chemical mechanical polishing pad is required to have adequate rigidity from the viewpoint of ensuring that the polished surface has flatness and high quality. On the other hand, a chemical mechanical polishing pad is required to follow swelling or warp of a wafer (i.e., exhibit toughness) from the viewpoint of ensuring uniformity. Generally, a chemical mechanical polishing pad with high rigidity (i.e., having small deformation in a wide horizontal area) can make a chip accurately flat, but tends to cause polishing defects (scratches), so that the uniformity of the entire wafer tends to be poor. A soft chemical mechanical polishing pad has a narrow deformation region in the horizontal direction, and cannot make each ship sufficiently flat. However, since polishing defects (scratches) rarely occur, the uniformity of the entire wafer increases.

Specifically, the rigidity and the toughness of a chemical mechanical polishing pad have a trade-off relationship with the CMP performance. Therefore, it is necessary to select a material having a good balance between rigidity and toughness for a chemical mechanical polishing pad.

### SUMMARY OF INVENTION

### TECHNICAL PROBLEM

However, a polyurethane pad has not necessarily been produced by using a material that has a good balance between rigidity and toughness. When using a thermoplastic polyurethane, the balance between rigidity and toughness can be controlled by combining the thermoplastic polyurethane with another resin or adding an additive such as a filler or a crosslinking agent to the thermoplastic polyurethane. However, a thermoplastic polyurethane having properties suitable for a polishing pad generally has a high flow temperature, and may not suitably be mixed with an additive or the like having poor heat resistance.

Accordingly, an object of the invention is to provide a polyurethane that exhibits excellent workability and a good balance between rigidity and toughness (mechanical characteristics).

Another object of the invention is to provide a polishing layer-forming composition that is chemically stable, and implements a polished surface having an improved flatness and a reduction in polishing defects (scratches).

A further object of the invention is to provide a chemical mechanical polishing pad that implements a polished surface having an improved flatness and a reduction in polishing defects (scratches).

### SOLUTION TO PROBLEM

The invention was conceived in order to solve at least some of the above objects, and may be implemented as the following aspects or application examples.

### [Application Example 1]

According to one aspect of the invention, there is provided a polyurethane produced by reacting a mixture including at least (A) a diisocyanate, (B) a polyol, and (C) a chain extender, the polyol (B) having a number average molecular weight of 400 to 5000, the chain extender (C) including (C1) a compound shown by a general formula (1) and (C2) a compound shown by a general formula (2), the compound (C1) and the compound (C2) having a number average molecular weight of less than 400, and a ratio "M₁/(M)+M₂)" calculated by using a number of moles (M₁) of the compound (C1) and a number of moles (M₂) of the compound (C2) being 0.25 to 0.9,

HO-(CR¹R²)₂ₘ₊₁-OH (1)

wherein R¹ and R² individually represent a hydrogen atom or a substituted or unsubstituted alkyl group having 1 to 6 carbon atoms, and m is an arbitrary integer from 1 to 13,

HO-(CR³R⁴)₂ₙ-OH (2)

wherein R³ and R⁴ individually represent a hydrogen atom or a substituted or unsubstituted alkyl group having 1 to 6 carbon atoms, and n is an arbitrary integer from 1 to 12.

### [Application Example 2]

In Application Example 1, R¹ and R² may be hydrogen atoms.

### [Application Example 3]

In Application Example 1 or 2, the compound (C1) may be at least one compound selected from 1,3-propanediol and 1,5-pentanediol.

### [Application Example 4]

In any one of Application Examples 1 to 3, R³ and R⁴ may be hydrogen atoms.

### [Application Example 5]

In any one of Application Examples 1 to 4, the compound (C2) may be at least one compound selected from ethylene glycol, 1,4-butanediol, 1,6-hexanediol, and 1,18-octadecanediol.

### [Application Example 6]

According to one aspect of the invention, there is provided a polishing layer-forming composition including at least water-soluble particles and the polyurethane according to any one of Application Examples 1 to 5.

### [Application Example 7]

In Application Example 6, the polishing layer-forming composition may further include a crosslinking agent.

### [Application Example 8]

According to one aspect of the invention, there is provided a chemical mechanical polishing pad that is produced by using the polishing layer-forming composition according to Application Example 6 or 7.

### [Application Example 9]

According to one aspect of the invention, there is provided a chemical mechanical polishing method including chemically and mechanically polishing a polishing target by using the chemical mechanical pad according to Application Example 8.

### EFFECTS OF INVENTION

Since the melting point (flow temperature) of the above polyurethane is lower than that of a polyurethane synthesized by using a single chain extender, the above polyurethane can be processed at a low temperature. Therefore, it is possible to add an additive (e.g., crosslinking agent or water-soluble particles) to the polyurethane without causing a reaction or deterioration. According to the above polyurethane, the tensile strength (elongation and fracture stress) can be improved without causing a significant decrease in hardness as compared with a polyurethane synthesized by using a single chain extender.

Since the above polishing layer-forming composition includes a polyurethane having the above properties, the polishing layer-forming composition is a chemically stable composition that does not cause a reaction with or a deterioration in an additive (e.g., crosslinking agent or water-soluble particles).

Since the above chemical mechanical polishing pad includes a polishing layer including a polyurethane having the above properties, the chemical mechanical polishing pad has adequate rigidity and toughness, and can suppress occurrence of scratches during chemical mechanical polishing.

### BRIEF DESCRIPTION OF DRAWINGS

FIG. 1 is a cross-sectional view schematically illustrating a chemical mechanical polishing pad according to one embodiment of the invention.
FIG. 2 is an enlarged view of an area I illustrated in FIG. 1.
FIG. 3 is a plan view schematically illustrating a chemical mechanical polishing pad according to one embodiment of the invention.
FIG. 4 is a plan view schematically illustrating a chemical mechanical polishing pad according to a first modification.
FIG. 5 is a plan view schematically illustrating a chemical mechanical polishing pad according to a second modification.

### DESCRIPTION OF EMBODIMENTS

Preferred embodiments of the invention are described in detail below. Note that the invention is not limited to the following embodiments. The invention includes various modifications that may be implemented without departing from the scope of the invention.

### 1. Polyurethane

A polyurethane according to one embodiment of the invention is produced by reacting a mixture including at least (A) a diisocyanate, (B) a polyol, and (C) a chain extender, the polyol (B) having a number average molecular weight of 400 to 5000, the chain extender (C) including (C1) a compound shown by a general formula (1) and (C2) a compound shown by a general formula (2), the compound (C1) and the compound (C2) having a number average molecular weight of less than 400, and a ratio "M₁/(M₁+M₂)" calculated by using the number of moles (M₁) of the compound (C1) and the number of moles (M₂) of the compound (C2) being 0.25 to 0.9,

HO-(CR¹R²)₂ₘ₊₁-OH (1)

wherein R¹ and R² individually represent a hydrogen atom or a substituted or unsubstituted alkyl group having 1 to 6 carbon atoms, and m is an arbitrary integer from 1 to 13,

HO-(CR³R⁴)₂ₙ-OH (2)

wherein R³ and R⁴ individually represent a hydrogen atom or a substituted or unsubstituted alkyl group having 1 to 6 carbon atoms, and n is an arbitrary integer from 1 to 12.

The monomer components that form the polyurethane according to one embodiment of the invention are described in detail below.

### 1.1. Diisocyanate (A)

The polyurethane according to one embodiment of the invention includes the diisocyanate (A) as a monomer component. A diisocyanate is a compound shown by the following general formula (3), and is an essential component for forming the urethane bond of a polyurethane.

OCN-R⁵-NCO (3)

wherein R⁵ represents an arbitrary divalent organic group.

Examples of the diisocyanate include an aromatic diisocyanate such as 2,4-tolylene diisocyanate, 2,6-tolylene diisocyanate, 2,2'-diphenylmethane diisocyanate, 2,4'-diphenylmethane diisocyanate, 4,4'-diphenylmethane diisocyanate, naphthalene diisocyanate, 1,5-naphthalene diisocyanate, p-phenylene diisocyanate, m-phenylene diisocyanate, p-xylene diisocyanate, and m-phenylene diisocyanate; an aliphatic diisocyanate such as ethylene diisocyanate, 2,2,4-trimethylhexamethylene diisocyanate, and 1,6-hexamethylene diisocyanate; an alicyclic diisocyanate such as isophorone diisocyanate and norbornene diisocyanate; and the like.

Among these, 2,4-tolylene diisocyanate, 2,6-tolylene diisocyanate, 4,4'-diphenylmethane diisocyanate, and isophorone diisocyanate are preferable from the viewpoint of availability and ease of controlling a reaction with a hydroxyl group (described later). These diisocyanates may be used either individually or in combination.

### 1.2. Polyol (B)

The polyurethane according to one embodiment of the invention includes the polyol (B) as a monomer component. A polyol is a generic name for alcohols having two or more hydroxyl groups. In one embodiment of the invention, it is preferable to use a polyol having 2 to 3 hydroxyl groups. The styrene-reduced number average molecular weight of the polyol (B), determined by gel permeation chromatography (GPC), is 400 to 5000, more preferably 400 to 4100, and particularly preferably 400 to 2500. If the number average molecular weight of the polyol (B) is within the above range, it is possible to synthesize a polyurethane having a good balance between rigidity (hardness and modulus of elasticity) and toughness (tensile strength). If the number average molecular weight of the polyol (B) exceeds 5000, the rigidity of the resulting polyurethane tends to decrease. If the number average molecular weight of the polyol (B) is less than 400, the toughness of the resulting polyurethane tends to decrease.

A polyol generally used in the field of polyurethanes may be used as the polyol (B). Examples of such a polyol include a hydroxy-terminated polyester, a polyether polyol, a polyester polyol, a polycarbonate polyol, a polyolefin polyol, a polyester carbonate polyol, a polyether carbonate polyol, a polyester amide polyol, and the like. Among these, a polyether polyol, a polyolefin polyol, and a polycarbonate polyol are preferable due to good hydrolysis resistance.

Examples of the polyether polyol include polytetramethylene glycol (PTMG), polypropylene glycol (PPG), polyethylene glycol (PEG), polyoxyethylene-propylene glycol (EO-PO), polyoxyethylene-bisphenol A ether, polyoxypropylene-bisphenol A, and the like.

Examples of the polyester polyol include polybutylene adipate, polyhexamethylene adipate, polycaprolactone polyol, and the like.

Examples of the polycarbonate polyol include a reaction product of an alkylene carbonate and a polyester glycol such as a polycaprolactone polyol, a reaction product of an organic dicarboxylic acid and a reaction mixture obtained by reacting ethylene carbonate with a polyhydric alcohol, and the like. Further examples of the polycarbonate polyol include a reaction product of a diol (e.g., 1,3-propanediol, 1,4-butanediol, 1,6-hexanediol, diethylene glycol, polyethylene glycol, polypropylene glycol, or polytetramethylene glycol) and phosgene, a diallyl carbonate (e.g., diphenyl carbonate), or a cyclic carbonate (e.g., propylene carbonate).

The polyolefin polyol is preferably a polyol having a carbon-carbon double bond in the molecule. Examples of such a polyol include a hydroxy-terminated polybutadiene, a castor oil-based polyol, a partially saponified ethylene-vinyl acetate copolymer, and the like. A carbon-carbon double bond can be introduced into the polyurethane skeleton by using a polyol having a carbon-carbon double bond in the molecule. The introduced carbon-carbon double bond can be used as a crosslinking point when crosslinking the polyurethane skeleton.

These polyols may be used either individually or in combination.

### 1.3. Chain extender (C)

The polyurethane according to one embodiment of the invention includes the chain extender (C) as a monomer component. The polyurethane according to one embodiment of the invention includes the compound (C1) shown by the following general formula (1) and the compound (C2) shown by the following general formula (2) as the chain extender (C).

HO-(CR¹R²)₂ₘ₊₁-OH (1)

wherein R¹ and R² individually represent a hydrogen atom or a substituted or unsubstituted alkyl group having 1 to 6 carbon atoms, m is an arbitrary integer from 1 to 13, preferably from 1 to 6.

HO-(CR³R⁴)₂ₙ-OH (2)

wherein R³ and R⁴ individually represent a hydrogen atom or a substituted or unsubstituted alkyl group having 1 to 6 carbon atoms, n is an arbitrary integer from 1 to 12, and preferably an arbitrary integer from 1 to 5.

The styrene-reduced number average molecular weight of each of the compound (C1) and the compound (C2), determined by gel permeation chromatography (GPC), is less than 400, more preferably 300 or less, and particularly preferably 40 to 300.

The polyurethane according to one embodiment of the invention has a low melting point (flow temperature), excellent workability, and high mechanical characteristics as compared with a polyurethane synthesized by using a single chain extender by utilizing the compound (C1) and the compound (C2) as the chain extender (C). The compound (C1) and the compound (C2) are described below.

### 1.3.1. Compound (C1)

Examples of the compound (C1) include dihydric alcohols having a low molecular weight, such as 1,3-propanediol, 1,3-butylene glycol, 1,5-pentanediol, neopentyl glycol, 3-methyl-1,5-pentanediol, 2-ethyl-1,3-hexanediol, 1,9-nonanediol, and dimethylolbutanoic acid.

Among these, 1,3-propanediol, 1,3-butylene glycol, and 1,5-pentanediol are preferable since it is easy to control a reaction with an isocyanate group. 1,3-Propanediol and 1,5-pentanediol (i.e., R¹ and R² are hydrogen atoms) are more preferable due to good reactivity with an isocyanate group.

### 1.3.2. Compound (C2)

Examples of the compound (C2) include divalent alcohols having a low molecular weight, such as ethylene glycol, 1,2-propanediol, 1,4-butanediol, 1,6-hexanediol, 1,18-octadecanediol, and 2-methyl-1,8-octanediol.

Among these, ethylene glycol, 1,2-propanediol, 1,4-butanediol, 1,6-hexanediol, and 1,18-octadecanediol are preferable since it is easy to control a reaction with an isocyanate group.

### 1.3.3. Content ratio of compound (C1) and compound (C2)

In the polyurethane according to one embodiment of the invention, the ratio "M₁/(M₁+M₂)" calculated by using the number of moles (M₁) of the compound (C1) and the number of moles (M₂) of the compound (C2) is 0.25 to 0.9, preferably 0.3 to 0.85, and more preferably 0.4 to 0.8. If the ratio "M₁/(M₁+M₂)" is within the above range, since the melting point (flow temperature) of the polyurethane is lower than that of a polyurethane synthesized by using a single chain extender, the polyurethane can be easily processed at a low temperature. It is also possible to improve the tensile strength (elongation and fracture stress) while causing a significant decrease in hardness as compared with a polyurethane synthesized by using a single chain extender. If the ratio "M₁/(M₁+M₂)" is less than 0.25 or exceeds 0.9, workability deteriorates due to a decrease in flowability. Moreover, a decrease in mechanical characteristics may also occur.

It is conjectured that the polyurethane according to one embodiment of the invention exhibits the above properties via the following mechanism.

A polyurethane is a block copolymer wherein a soft segment formed of a polyol is bonded to a hard segment formed of an isocyanate and a chain extender (short-chain diol). The hard segment having crystallinity mainly contributes to the rigidity (e.g., hardness and modulus of elasticity) of the polyurethane. On the other hand, the soft segment having noncrystallinity mainly contributes to the toughness (e.g., tensile strength) of the polyurethane.

For example, when the hard segment is formed of single diol repeating units, the urethane bonds that form the hard segment are regularly arranged to improve the crystallinity. The polyurethane thus exhibits excellent rigidity. On the other hand, since the melting point of the polyurethane increases due to a rigid structure of the hard segment, and the toughness of the polyurethane decreases since the flexibility of the soft segment that connects the hard segments significantly decreases. As the result, a polyurethane that exhibits mechanical characteristics and workability cannot be obtained.

On the other hand, when the hard segment is formed of diol units that include two or more repeating units that differ in the carbon chain length between the hydroxyl groups, and differ in the number of repeating units (i.e., even number or odd number), the urethane bonds that form the hard segment are irregularly arranged, so that the crystallinity is disordered, and the melting point decreases. Moreover, since the flexibility of the soft segment is affected to only a small extent as compared with a hard segment that is formed of diol units that include a single repeating unit, the polyurethane exhibits high toughness. As the result, a polyurethane that can be easily processed (e.g., mixed (kneaded) or molding with heating), and exhibits excellent mechanical characteristics can be obtained.

Note that the properties of the polyurethane may also be controlled by changing the type of polyol that forms the soft segment. However, a polyurethane that exhibits excellent workability and mechanical characteristics as mentioned above cannot be obtained even if two or more polyols that differ in carbon chain length are used in combination, or a polyol that exhibits crystallinity and a polyol that exhibits noncrystallinity are used in combination.

### 1.4. Additive

The polyurethane according to one embodiment of the invention includes the diisocyanate (A), the polyol (B), and the chain extender (C) as essential components. The polyurethane may include an additive in addition to these components. Examples of the additive include a catalyst, an antioxidant, a UV absorber, a lubricant, a peptiser, and the like.

### 1.5. Method of producing polyurethane

The polyurethane according to one embodiment of the invention is produced by a known polyurethane reaction. Specifically, the polyurethane may be produced by mixing and stirring the diisocyanate (A), the polyol (B), and the chain extender (C) (compound (C1) and compound (C2)) to prepare a monomer mixture, and reacting the monomers at room temperature to 150°C under atmospheric pressure. The monomers may be reacted in an arbitrary order. The monomers may be simultaneously added and reacted.

The content of the diisocyanate (A) in the monomer mixture is preferably 20 to 60 mass%, and more preferably 25 to 55 mass%.

The content of the polyol (B) in the monomer mixture is preferably 30 to 70 mass%, and more preferably 35 to 65 mass%.

The content of the chain extender (C) in the monomer mixture is preferably 1 to 15 mass%, and more preferably 2 to 12 mass%.

If the content of each component in the monomer mixture is within the above range, a high-molecular-weight polyurethane that exhibits excellent properties can be obtained. The polyurethane according to one embodiment of the invention includes the compound (C1) and the compound (C2) as the chain extender (C). The polyurethane according to one embodiment of the invention is **characterized in that** the compound (C1) and the compound (C2) are included as the chain extender (C) in a ratio within the above range. The polyol included in the polyurethane may be analyzed (measured) by the pyrolysis method disclosed in JP-A-2002-371121.

### 1.6. Properties of polyurethane

### 1.6.1. Durometer D hardness

The durometer D hardness may be used as an index for determining the hardness of the polyurethane. The durometer D hardness may be measured in accordance with JIS K 6253.

The durometer D hardness of the polyurethane according to one embodiment of the invention is preferably 30 or more, and more preferably 35 or more.

### 1.6.2. Fracture stress, fracture strain, and tensile product

The fracture stress, the fracture strain, and the tensile product may be used as indices for determing the mechanical characteristics of the polyurethane. The fracture stress and the fracture strain may be measured by a tensile test in accordance with JIS K 6251. The tensile product is obtained by calculating the product of the fracture stress and the fracture strain.

The fracture stress of the polyurethane according to one embodiment of the invention is preferably 4 MPa or more, more preferably 5 MPa or more, and particularly preferably 6 MPa or more. The fracture strain of the polyurethane according to one embodiment of the invention is preferably 200% or more, more preferably 300% or more, and particularly preferably 400% or more. The tensile product of the polyurethane according to one embodiment of the invention is preferably 800 MPa or more, more preferably 1500 MPa or more, and particularly preferably 2400 MPa or more. If these properties are within the above range, the polyurethane exhibits excellent tensile strength (elongation and fracture stress).

### 1.6.3. Flow temperature

The flow temperature may be used as an index for determining the workability of the polyurethane in terms of temperature. The flow temperature may be measured in accordance with "10. Flow test" of JIS K 7311. Specific measurement conditions are described in the examples.

The flow temperature of the polyurethane according to one embodiment of the invention is preferably 60 to 120°C, more preferably 70 to 110°C, and particularly preferably 80 to 100°C. If the flow temperature is within the above range, the polyurethane can be processed at a low temperature of 70 to 130°C. Therefore, an additive (e.g., crosslinking agent or water-soluble particles) can be added without causing a reaction or a deterioration.

### 2. Polishing layer-forming composition

A polishing layer-forming composition according to one embodiment of the invention includes at least water-soluble particles and the above polyurethane. Since the polishing layer-forming composition according to one embodiment of the invention includes the above polyurethane, the polishing layer-forming composition is a chemically stable composition that allows addition of an additive (e.g., crosslinking agent or water-soluble particles) without causing a reaction or deterioration.

### 2.1. Water-soluble particles

The polishing layer-forming composition according to one embodiment of the invention includes the water-soluble particles. In a chemical mechanical polishing pad obtained by molding the polishing layer-forming composition according to one embodiment of the invention, the water-soluble particles are used so that they are removed from the surface of a polishing layer of the chemical mechanical polishing pad by contact with a chemical mechanical polishing aqueous dispersion (hereinafter may be referred to as "slurry"), and they form pores that can hold the slurry. The water-soluble particles are removed due to dissolution, swelling, and the like upon contact with water or an aqueous mixed medium included in the chemical mechanical polishing dispersion.

The water-soluble particles are not particularly limited, examples being an organic water-soluble particle and an inorganic water-soluble particle.

Examples of the material for the organic water-soluble particle include a saccharide (e.g., polysaccharide (e.g., starch, dextrin and cyclodextrin), lactose, and mannitol), a cellulose (e.g., hydroxypropyl cellulose and methyl cellulose), a protein, polyvinyl alcohol, polyvinylpyrrolidone, polyacrylic acid, polyethylene oxide, a water-soluble photosensitive resin, sulfonated polyisoprene, a sulfonated isoprene copolymer, and the like.

Examples of the material for the inorganic water-soluble particle include potassium acetate, potassium nitrate, potassium carbonate, potassium hydrogencarbonate, potassium chloride, potassium bromide, potassium phosphate, magnesium nitrate, potassium sulfate, magnesium sulfate, calcium nitrate, and the like.

These materials may be used either individually or in combination. It is also possible to use one type of the water-soluble particle formed of the materials, or two or more types of the water-soluble particles formed of different materials.

The average particle size of the water-soluble particles is preferably 0.1 to 500 micrometers, and more preferably 0.5 to 100 micrometers. The average particle size of the water-soluble particles can be measured with a laser scattering diffraction measuring instrument. If the average particle size of the water-soluble particles is within this range, the size of pores formed by removal of the water-soluble particles can be controlled within an appropriate range. Thus, it is possible to obtain a chemical mechanical polishing pad that has an excellent capability of holding the chemical mechanical polishing aqueous dispersion, a high polishing rate during chemical mechanical polishing, and excellent mechanical strength.

In the polishing layer-forming composition according to one embodiment of the invention, the content of the water-soluble particles is preferably 1 to 300 parts by mass, more preferably 1 to 200 parts by mass, and particularly preferably 3 to 150 parts by mass, based on the polyurethane of 100 parts by mass. If the content of the water-soluble particles is within this range, it is possible to produce a chemical mechanical polishing pad that exhibits a high polishing rate, appropriate hardness, and appropriate other mechanical strengths during chemical mechanical polishing.

### 2.2. Crosslinking agent

The polishing layer-forming composition according to one embodiment of the invention may include a crosslinking agent. A crosslinking agent is used for crosslinking a polyurethane. By incorporating a crosslinking agent, it is possible to provide a polishing layer with a crosslinked structure when the polishing layer is formed with the polishing layer-forming composition according to one embodiment of the invention.

In the polishing layer-forming composition according to one embodiment of the invention, the above uncrosslinked polyurethane and the crosslinking agent can be mixed at low temperature. Accordingly, a chemically stable composition including a polyurethane and a crosslinking agent can be obtained without reacting the crosslinking agent.

By heating a polishing layer-forming composition including a crosslinking agent at a temperature in a range where the crosslinking agent reacts, it is possible to easily crosslink a polyurethane included in a molded product.

The method of crosslinking a polyurethane is not particularly limited, and it is preferably a chemical crosslinking method. Examples of the crosslinking agent used in the chemical crosslinking method include an organic peroxide, sulfur, a sulfur compound, and the like. Among these, the chemical crosslinking method using an organic peroxide that produces radicals by heating is more preferable since an organic peroxide exhibits excellent handling properties, and it does not contaminate a polishing target during chemical mechanical polishing.

Examples of the organic peroxide include ketone peroxide, peroxyketal, hydro peroxide, dialkyl peroxide, diacyl peroxide, peroxycarbonate, peroxyester, and the like. Among these, dialkyl peroxide is particularly preferable in terms of crosslinking rate, specific examples being dicumyl peroxide, 2,5-dimethyl-2,5-bis(t-butylperoxy)hexane, and the like. The organic peroxides may be used either individually or in combination.

The content of the crosslinking agent in the polishing layer-forming composition according to one embodiment of the invention is preferably 0.1 to 10 parts by mass, more preferably 0.1 to 5 parts by mass, and particularly preferably 0.1 to 3 parts by mass, based on 100 parts by mass of polyurethane. If the content of the crosslinking agent is within this range, it is possible to form a polishing layer that exhibits excellent mechanical properties such as hardness, modulus of elasticity, and residual distortion. If the content of the crosslinking agent is less than this range, a polyurethane may not be sufficiently crosslinked, and hardness and modulus of elasticity of an obtained polishing layer decrease. If chemical mechanical polishing is performed by using a chemical mechanical polishing pad having such an insufficiently-crosslinked polishing layer, a polishing rate of a polishing target decreases, and it may be difficult to uniformly planarize the polishing target since the residual distortion of the polishing layer increases. On the other hand, if the content of the crosslinking agent exceeds this range, the life of a polishing layer is reduced since hardness and modulus of elasticity of an obtained polishing layer increases. If chemical mechanical polishing is performed by using a chemical mechanical polishing pad having a polishing layer with such a reduced life, the number of scratches on a polishing target may increase.

### 2.3. Other additives

The polishing layer-forming composition according to one embodiment of the invention may include an additive such as a crosslinking promoter to promote the crosslinking reaction and an organic or inorganic filler to adjust the hardness of a polishing layer to an appropriate value, insofar as the objects of the invention are not impaired.

### 2.4. Method of producing polishing layer-forming composition

The method of producing the polishing layer-forming composition according to one embodiment of the invention is not particularly limited. For example, the polishing layer-forming composition may be obtained by measuring off specific amounts of the above materials and mixing them with a mixer or the like. As the mixer, any publicly known mixer may be used, examples being a roller, a kneader, a Banbury mixer, an extruder (single-screw extruder and multi-screw extruder), and the like.

### 3. Chemical mechanical polishing pad

The chemical mechanical polishing pad according to one embodiment of the invention includes a polishing layer obtained by molding the above polishing layer-forming composition. Since the chemical mechanical polishing pad according to one embodiment of the invention includes a polishing layer that includes the polyurethane having the properties as mentioned above, it exhibits adequate rigidity and appropriate toughness, and particularly it can prevent scratches from occurring during chemical mechanical polishing.

The configuration of the chemical mechanical polishing pad according to one embodiment of the invention is not limited particularly insofar as it has a polishing layer obtained by molding the above polishing layer-forming composition. The configuration of the chemical mechanical polishing pad according to one embodiment of the invention is described in detail below with reference to the drawings.

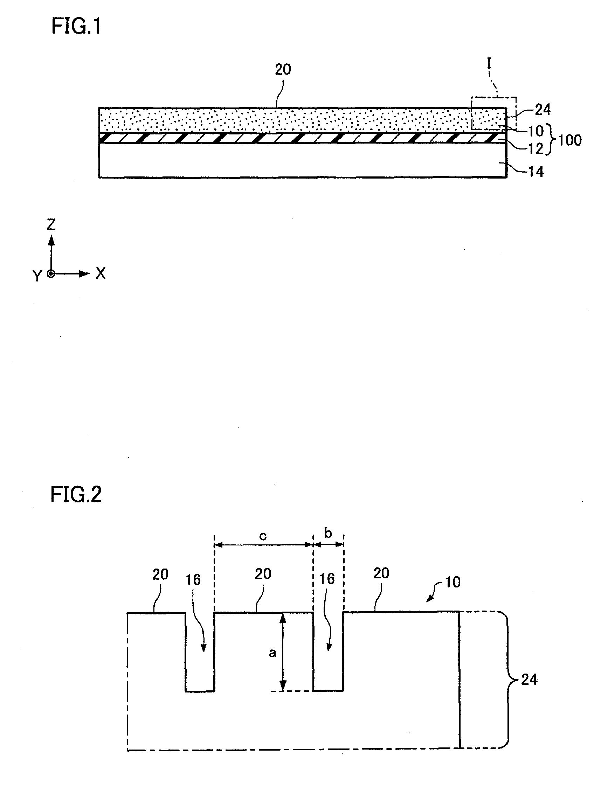

FIG. 1 is a cross-sectional view schematically illustrating an example of the chemical mechanical polishing pad according to one embodiments of the invention. As illustrated in FIG. 1, a chemical mechanical polishing pad 100 includes a polishing layer 10 and a support layer 12 formed on the surface that contacts a platen 14 of a polishing apparatus on the polishing layer 10. The details of the polishing layer 10 and the support layer 12 are individually described below.

### 3.1. Polishing layer

The planar shape of the polishing layer 10 is not particularly limited. For example, the polishing layer 10 may have a circular planar shape. If the polishing layer 10 has a circular planar shape, the diameter is preferably 150 to 1200 mm, and more preferably 500 to 800 mm. The thickness of the polishing layer 10 is preferably 0.5 to 5.0 mm, more preferably 1.0 to 3.0 mm, and particularly preferably 1.5 to 3.0 mm.

FIG. 2 is an enlarged view of an area I in FIG. 1, and a cross-sectional view schematically illustrating a detailed shape of the polishing layer 10. As illustrated in FIG. 2, a plurality of grooves 16 may be formed on a surface 20 (hereinafter referred to as "polishing surface") that contacts a polishing target of the polishing layer 10. The grooves 16 serve as a path that holds a chemical mechanical polishing aqueous dispersion supplied during chemical mechanical polishing, uniformly distributes the aqueous dispersion over the polishing surface, temporarily stores waste such as polishing waste and a spent aqueous dispersion, and discharges them to the outside.

The cross-sectional shape of the grooves 16 is not particularly limited. As illustrated in FIG. 2, the grooves 16 may have a polygonal shape (e.g., a rectangular and the like), a shape of the letter "U", or the like. A depth a of the grooves 16 may be preferably 0.1 to 2.5 mm, and more preferably 0.2 to 2.0 mm. A width b of the grooves 16 may be preferably 0.1 to 5.0 mm, and more preferably 0.2 to 3.0 mm. A distance c between the grooves 16 adjacent to each other on the polishing surface 20 may be preferably 0.05 to 100 mm, and more preferably 0.1 to 10 mm. The grooves 16 may be provided while keeping a constant distance within the above range. If the grooves 16 have shapes within the above ranges, it is possible to easily produce a chemical mechanical polishing pad that exhibits an excellent effect of reducing scratches in a polishing target surface and has a long life.

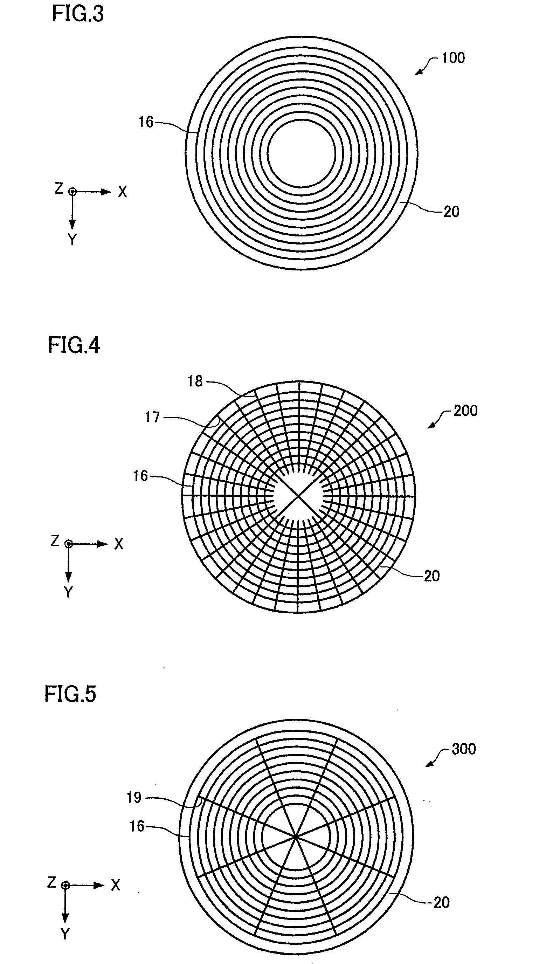

FIG. 3 is a plan view of a chemical mechanical polishing pad 100 according to one embodiment of the invention. As illustrated in FIG. 3, the grooves 16 may be formed in the shape of a plurality of concentric circles that gradually increase in diameter from the center of the polishing surface 20 toward the outer edge.

The polishing layer 10 may be obtained by molding the above polishing layer-forming composition. For a method of molding the polishing layer 10, when a crosslinking agent is included in the above polishing layer-forming composition, the polishing layer 10 may be molded by crosslinking the composition at preferably 160 to 220°C, and more preferably 170 to 200°C. When a crosslinking agent is not included in the above polishing layer-forming composition, the polishing layer 10 may be molded by a method wherein the polishing layer-forming composition is plasticized, molded with a press machine or injection molding machine, and then solidified by cooling, or a method wherein the polishing layer-forming composition is plasticized/sheeted with an extruder equipped with a T-die. After molding as mentioned above, the grooves 16 may be formed by cutting. The outer shape of the polishing layer 10 and the grooves 16 may also be formed at the same time by molding the above polishing layer-forming composition by using a mold provided with a pattern of the grooves 16.

FIG. 4 is a plan view of a chemical mechanical polishing pad 200 according to a first modification, and it corresponds to FIG. 3. The chemical mechanical polishing pad 200 according to the first modification differs from the polishing layer 10 in that, in addition to the circular grooves 16, the chemical mechanical polishing pad 200 further includes a plurality of grooves 17 and grooves 18 that extend radially from the center of the polishing surface 20 toward the outer edge. The grooves 17 and 18 may extend from an arbitrary position in the center area toward the outer edge. The grooves 17 and 18 may have a linear shape, an arc shape, or a combination thereof, for example. The term "center area" used herein refers to an area enclosed by a circle having a radius of 50 mm and formed around the center of gravity of the polishing layer as the center point. The grooves 17 and 18 may have the same cross-sectional shape and surface roughness as that of the grooves 16. The remaining configuration of the chemical mechanical polishing pad 200 according to the first modification is the same as the configuration of the polishing layer 10 described with reference to FIGS. 1 and 2. Therefore, description thereof is omitted.

FIG. 5 is a plan view of a chemical mechanical polishing pad 300 according to a second modification, and it corresponds to FIG. 3. The chemical mechanical polishing pad 300 according to the second modification differs from the above polishing layer 10 in that, in addition to the circular grooves 16, the chemical mechanical polishing pad 300 further includes a plurality of grooves 19 that extend radially from the center of the polishing surface 20 toward the outer edge. The cross-sectional shape of the grooves 19 may be the same as that of the above grooves 16. The remaining configuration of the chemical mechanical polishing pad 300 according to the second modification is the same as the configuration of the polishing layer 10 described with reference to FIGS. 1 and 2. Therefore, description thereof is omitted.

### 3.2. Support layer

In the chemical mechanical polishing pad 100, the support layer 12 is used to support the polishing layer 10 on the platen 14 of the polishing apparatus. The support layer 12 may be an adhesive layer or a cushion layer that has adhesive layers on the upper and lower sides.

The adhesive layer may be a pressure-sensitive adhesive sheet, for example. The thickness of the pressure-sensitive adhesive sheet is preferably 50 to 250 micrometers. If the pressure-sensitive adhesive sheet has a thickness of 50 micrometers or more, a pressure applied to the polishing surface 20 of the polishing layer 10 can be sufficiently reduced. If the pressure-sensitive adhesive sheet has a thickness of 250 micrometers or less, it is possible to obtain a chemical mechanical polishing pad 100 having such a uniform thickness that the polishing performance is not affected by elevations or depressions.

The material for the pressure-sensitive adhesive sheet is not particularly limited insofar as the polishing layer 10 can be secured on the platen 14 of the polishing apparatus. It is preferable to use an acrylic material or a rubber material having a modulus of elasticity lower than that of the polishing layer 10.

The adhesive strength of the pressure-sensitive adhesive sheet is not particularly limited insofar as the chemical mechanical polishing pad can be secured on the platen 14 of the polishing apparatus. It is preferred that the pressure-sensitive adhesive sheet have an adhesive strength of 3 N/25 mm or more, more preferably 4 N/25 mm or more, and particularly preferably 10 N/25 mm or more, as measured in accordance with JIS Z 0237.

The material for the cushion layer is not particularly limited insofar as the material has a hardness lower than that of the polishing layer 10. The cushion layer may be formed of a porous body (foam) or a non-porous body. Examples of the cushion layer include a layer wherein a polyurethane foam or the like is molded. The thickness of the cushion layer is preferably 0.1 to 5.0 mm, and more preferably 0.5 to 2.0 mm.

### 4. Chemical mechanical polishing method

The chemical mechanical polishing method according to one embodiment of the invention includes chemically and mechanically polishing a polishing target by using the above chemical mechanical polishing pad. Since the above chemical mechanical polishing pad includes the polishing layer including the polyurethane with the properties as mentioned above, it exhibits adequate rigidity and appropriate toughness, and particularly it can prevent scratches from occurring during chemical mechanical polishing.

In the chemical mechanical polishing method according to one embodiment of the invention, a commercially available chemical mechanical polishing apparatus may be used. Examples of the commercially available chemical mechanical polishing apparatus include EPO-112, EPO-222 (manufactured by Ebara Corporation), LGP 510, LGP 552 (manufactured by Lapmaster SFT), Mirra (manufactured by Applied Materials), and the like.

Preferred polishing conditions are appropriately set depending on the chemical mechanical polishing apparatus. For example, when using a chemical mechanical polishing apparatus "Mirra", the following conditions may be used.
- Head rotational speed: preferably 30 to 150 rpm, and more preferably 40 to 120 rpm
- Head load: preferably 0.8 to 2.8 psi, and more preferably 1.4 to 2.1 psi
- Platen rotational speed: preferably 30 to 150 rpm, and more preferably 40 to 120 rpm
- Ratio of platen rotational speed/head rotational speed: preferably 0.5 to 2, and more preferably 0.7 to 1.5
- Dispersion supply rate: preferably 50 to 300 cm³/min, and more preferably 100 to 200 cm³/min

A suitable chemical mechanical polishing aqueous dispersion may be selected appropriately depending on a polishing target (copper film, insulating film, low-dielectric-constant insulating film, and the like).

### 5. Examples

The invention is further described in detail below by way of examples. Note that the invention is not limited to the following examples.

### 5.1. Production of polyurethane

### 5.1.1. Example 1

A four-neck separable flask (21) equipped with a stirrer was charged with 35.0 parts by mass of hydroxy-terminated polybutadiene ("NISSO PB G-1000" manufactured by Nippon Soda Co., Ltd., Mn=1516, hereinafter referred to as "G-1000") and 28.5 parts by mass of polytetramethylene glycol ("PTG-1000SN" manufactured by Hodogaya Chemical Co., Ltd., Mn=1012, hereinafter referred to as "PTG-1000") as the polyol (B) in air. The mixture was stirred at 60°C.

After adding 29.8 parts by mass of 4,4'-diphenylmethane diisocyanate ("MILLIONATE MT" manufactured by Nippon Polyurethane Industry Co., Ltd., hereinafter referred to as "MDI", dissolved in an oil bath at 80°C) as the diisocyanate
(A), the components were mixed for 10 minutes with stirring. After adding 1.9 parts by mass of 1,5-pentanediol ("1,5-Pentanediol" manufactured by Ube Industries, Ltd.,
hereinafter referred to as "15PD") as Component (C1) of the chain extender (C) and 4.8 parts by mass of 1,4-butanediol ("14BG" manufactured by Mitsubishi Chemical Corp.,
hereinafter referred to as "14BG") as Component (C2), the components were mixed with stirring.

The resulting mixture was spread over a surface-treated SS vat, allowed to stand and react at 110°C for one hour, and annealed at 80°C for 16 hours to obtain a thermoplastic polyurethane A.

### 5.1.2. Examples 2 to 18, Comparative Examples 1 to 9

Thermoplastic polyurethanes B to AA of Examples 2 to 18 and Comparative Examples 1 to 9 were produced in the same manner as in Example 1, except for changing the types and amounts of each component of the diisocyanate (A), the polyol (B), and the chain extender (C) as shown in Tables 1 to 3.

The abbreviations of the compounds in Tables 1 to 3 are as follows.
- "PTG-650": polytetramethylene glycol ("PTG-650SN" manufactured by Hodogaya Chemical Co., Ltd., Mn=657)
- "PTG-2000": polytetramethylene glycol ("PTG-2000SN" manufactured by Hodogaya Chemical Co., Ltd., Mn=2004)
- "PEG-200": polyethylene glycol ("PEG-200" manufactured by Sanyo Chemical Industries, Ltd., Mn=200)
- "PEG-400": polyethylene glycol ("PEG-400" manufactured by Sanyo Chemical Industries, Ltd., Mn=401)
- "PEG-4000": polyethylene glycol ("PEG-4000" manufactured by Sanyo Chemical Industries, Ltd., Mn=4026)
- "PEG-10000": polyethylene glycol ("PEG-10000" manufactured by Sanyo Chemical Industries, Ltd., Mn=10000)
- "13PD": 1,3-propanediol ("1,3-Propanediol" manufactured by Shell Chemicals Japan Ltd.)
- "16HD": 1,6-hexanediol ("1,6-Hexanediol" manufactured by Ube Industries, Ltd.)
- "1180D": 1,18-octadecanediol (manufactured by Aldrich Chemical Company, Inc.)
- "EG": ethylene glycol ("Ethylene glycol" manufactured by Nippon Shokubai Co., Ltd.)

In Tables 1 to 3, the number average molecular weight (Mn) of the polyol (B) refers to a value measured by gel permeation chromatography (GPC) (instrument: "HLC-8120", manufactured by Tosoh Corp., column: "TSK-GEL alpha-M").

### 5.2. Evaluation of properties of polyurethane

### 5.2.1 Hardness

The durometer D hardness of the polyurethane obtained in "5.1. Production of polyurethane" was measured. The durometer D hardness was measured in accordance with JIS K 6253. The results are shown in Tables 1 to 3.

### 5.2.2. Fracture stress and fracture strain

The fracture stress and fracture strain of the polyurethane obtained in "5.1. Production of polyurethane" were measured. The fracture stress and fracture strain were measured by a tensile test in accordance with JIS K 6251. Then, the product of the measured fracture stress and the measured fracture strain was calculated as a tensile product. A tensile product can be an index for mechanical characteristics of a polyurethane. The results are shown in Tables 1 to 3. The fracture stress is preferably 4 MPa or more, more preferably 5 MPa or more, and particularly preferably 6 MPa or more. The fracture strain is preferably 200% or more, more preferably 300% or more, and particularly preferably 400% or more. The tensile product is preferably 800 MPa or more, more preferably 1500 MPa or more, and particularly preferably 2400 MPa or more.

### 5.2.3. Flow initiation temperature

The flow temperature (processing temperature) of the polyurethane obtained in "5.1. Production of polyurethane" was measured. The flow temperature was measured by a method in accordance with "10. Flow test" in JIS K 7311. A measurement apparatus and measurement conditions for measuring the flow temperature are as follows.
- Tester: CFT-500 (manufactured by Shimadzu Corp.)
- Preheat condition: 90°C x 4 minutes
- Temperature rise rate: 3°C/min
- Initiation temperature: 90°C
- Test load: 98N
- Die used: diameter of 1 mm, length of 1 mm

Specifically, after preheating a test sample of a thermoplastic polyurethane under these conditions, a temperature rise was initiated at the same time as applying a test load. A temperature at which the test sample began to flow from the die was used as a flow temperature (processing temperature) of the polyurethane. A flow temperature can be an index for workability of a polyurethane. The results are shown in Tables 1 to 3. The flow temperature is preferably 60 to 120°C, more preferably 70 to 110°C, and particularly preferably 80 to 100°C.

### 5.2.4. Measurement of melt flow rate (MFR)

An MFR measurement of the polyurethane obtained in "5.1. Production of polyurethane" was performed. The MFR measurement was performed by a method in accordance with "Plastic - test method for melt flow rate (MFR) and melt volume flow rate I (MVR) of thermoplastic plastic" in JIS K 7210. Specifically, the MFR (g/10 minutes) measurement of the thermoplastic polyurethane was performed under the following conditions. An MFR can be an index for workability of a polyurethane. The results are shown in Tables 1 to 3. The MFR is preferably 10 or more, more preferably 15 or more, and particularly preferably 25 or more.
- Tester: 120-SAS-2000 (manufactured by Yasuda Seiki Seisakusho LTD.)
- Cylinder temperature: 130°C
- Test load: 98 N

**TABLE 1**

| | | Example 1 | Example 2 | Example 3 | Example 4 | Example 5 | Example 6 | Example 7 | Example 8 | Example 9 |
|---|---|---|---|---|---|---|---|---|---|---|
| Polyurethane | | A | B | C | D | E | F | G | H | I |
| Diisocyanate (A) | Monomer | MDI | MDI | MDI | MDI | MDI | MDI | MDI | MDI | MDl |
| | Parts by mass | 29.8 | 30.5 | 29.0 | 29.8 | 29.8 | 29.6 | 29.5 | 29.8 | 29.9 |
| Polyol (B) | Compound name | G-1000 | G-1000 | G-1000 | G-1000 | G-1000 | G-1000 | G-1000 | G-1000 | PTG-1000 |
| | Number average molecular weight (Mn) | 1516 | 1516 | 1516 | 1516 | 1516 | 1516 | 1516 | 1516 | 1012 |
| | Parts by mass | 35.0 | 34.9 | 35.0 | 35.1 | 35.0 | 35.0 | 35.0 | 35.0 | 64.3 |
| | Compound name | PTG-1000 | PEG-400 | PEG-4000 | PTG-1000 | PTG-1000 | PTG-1000 | PTG-1000 | PTG-1000 | |
| | Number average molecular weight (Mn) | 1012 | 401 | 4026 | 1012 | 1012 | 1012 | 1012 | 1012 | |
| | Parts by mass | 28.5 | 32.6 | 27.6 | 28.4 | 28.3 | 28.3 | 27.8 | 28.5 | |
| Chain extender (C) | C1 | 15PD | 15PD | 15PD | 15PD | 15PD | 15PD | 15PD | 13PD | 15PD |
| | Number average molecular weight (Mn) | 104 | 104 | 104 | 104 | 104 | 104 | 104 | 76 | 104 |
| | Parts by mass | 1.9 | 0.6 | 2.3 | 2.2 | 3.0 | 4.5 | 4.4 | 3.0 | 3.7 |
| | C2 | 14BG | 14BG | 14BG | 14BG | 14BG | 14BG | 16HD | 16HD | 14BG |
| | Number average molecular weight (Mn) | 90 | 90 | 90 | 90 | 90 | 90 | 118 | 118 | 90 |
| | Parts by mass | 4.8 | 1.4 | 6.1 | 4.5 | 3.9 | 2.6 | 3.3 | 3.4 | 2.1 |
| | Molar ratio "M1/(M1+M2)" | 0.26 | 0.27 | 0.25 | 0.30 | 0.40 | 0.60 | 0.60 | 0.60 | 0.60 |
| Hardness | Duro-D | 39 | 45 | 30 | 38 | 39 | 40 | 40 | 38 | 41 |
| Tensile properties | Fracture stress (MPa) | 4.5 | 5.2 | 4.0 | 4.8 | 5.2 | 8.9 | 9.6 | 7.2 | 9.3 |
| | Fracture strain (%) | 224 | 203 | 1420 | 285 | 366 | 696 | 624 | 532 | 725 |
| | Tensile product | 1008 | 1056 | 5680 | 1368 | 1903 | 6194 | 5990 | 3830 | 6743 |
| Workability | Flow temperature (°C) | 113 | 110 | 115 | 110 | 108 | 92 | 98 | 101 | 95 |
| | MFR | 10 | 10 | 12 | 12 | 14 | 26 | 49 | 20 | 25 |

**TABLE 2**

| | | Example 10 | Example 11 | Example 12 | Example 13 | Example 14 | Example 15 | Example 16 | Example 17 | Example 18 |
|---|---|---|---|---|---|---|---|---|---|---|
| Polyurethane | | J | K | L | M | N | O | P | Q | R |
| Diisocyanate (A) | Monomer | MDI | MDI | MDI | MDI | MDI | MDI | MDI | MDI | MDI |
| | Parts by mass | 29.7 | 29.7 | 29.7 | 29.6 | 29.6 | 29.9 | 29.2 | 27.5 | 29.7 |
| Polyol (B) | Compound name | PTG-650 | PTG-2000 | G-1000 | G-1000 | G-1000 | G-1000 | G-1000 | G-1000 | G-1000 |
| | Number average molecular weight (Mn) | 657 | 2004 | 1516 | 1516 | 1516 | 1516 | 1516 | 1516 | 1516 |
| | Parts by mass | 68.6 | 61.3 | 35.0 | 35.0 | 35.0 | 35.0 | 35.0 | 35.0 | 35.0 |
| | Compound name | | | PTG-1000 | PTG-1000 | PTG-1000 | PTG-1000 | PTG-1000 | PTG-1000 | PTG-1000 |
| | Number average molecular weight (Mn) | | | 1012 | 1012 | 1012 | 1012 | 1012 | 1012 | 1012 |
| | Parts by mass | | | 28.1 | 28.1 | 28.1 | 28.8 | 28.5 | 25.5 | 29.3 |
| Chain extender (C) | C1 | 15PD | 15PD | 15PD | 15PD | 15PD | 13PD | 15PD | 15PD | 15PD |
| | Number average molecular weight (Mn) | 104 | 104 | 104 | 104 | 104 | 76 | 104 | 104 | 104 |
| | Parts by mass | 1.1 | 5.7 | 5.9 | 6.3 | 6.6 | 1.4 | 8.0 | 4.2 | 4.6 |
| | C2 | 14BG | 14BG | 14BG | 14BG | 14BG | 14BG | 14BG | 1180D | EG |
| | Number average molecular weight (Mn) | 90 | 90 | 90 | 90 | 90 | 90 | 90 | 287 | 62 |
| | Parts by mass | 0.6 | 3.3 | 1.3 | 1.0 | 0.7 | 4.9 | 0.8 | 7.8 | 1.4 |
| | Molar ratio "M1/(M1+M2)" | 0.61 | 0.60 | 0.80 | 0.85 | 0.89 | 0.25 | 0.90 | 0.60 | 0.66 |
| Hardness | Duro-D | 43 | 38 | 39 | 39 | 38 | 39 | 39 | 31 | 45 |
| Tensile properties | Fracture stress (MPa) | 12.3 | 6.7 | 6.2 | 5.6 | 5.1 | 4.7 | 4.8 | 4.0 | 13.0 |
| | Fracture strain (%) | 452 | 1023 | 408 | 369 | 203 | 235 | 209 | 1520 | 520 |
| | Tensile product | 5560 | 6854 | 2530 | 2066 | 1035 | 1105 | 1003 | 6080 | 6760 |
| Workability | Flow temperature (°C) | 99 | 96 | 90 | 109 | 115 | 113 | 110 | 110 | 99 |
| | MFR | 28 | 26 | 78 | 15 | 23 | 10 | 20 | 10 | 21 |

**TABLE 3**

| | | Comparative Example 1 | Comparative Example 2 | Comparative Example 3 | Comparative Example 4 | Comparative Example 5 | Comparative Example 6 | Comparative Example 7 | Comparative Example 8 | Comparative Example 9 |
|---|---|---|---|---|---|---|---|---|---|---|
| Polyurethane | | S | T | U | V | W | X | Y | Z | AA |
| Diisocyanate (A) | Monomer | MDI | MDI | MDI | MDI | MDI | MDI | MDI | MDI | MDI |
| | Parts by mass | 29.9 | 29.6 | 29.8 | 44.4 | 30.0 | 29.7 | 29.5 | 29.8 | 29.2 |
| Polyol | Compound name | G-1000 | G-1000 | G-1000 | G-1000 | G-1000 | PTG-1000 | G-1000 | G-1000 | G-1000 |
| | Number average molecular weight (Mn) | 1516 | 1516 | 1516 | 1516 | 1516 | 1012 | 1516 | 1516 | 1516 |
| | | 35.0 | 35.0 | 35.0 | 35.0 | 35.0 | 65.1 | 35.0 | 35.0 | 35 |
| | (B) Parts by mass Compound name | PTG-1000 | PTG-1000 | PTG-1000 | PEG-200 | PEG-10000 | | PTG-1000 | PTG-1000 | PTG-1000 |
| | Number average molecular weight (Mn) | 1012 | 1012 | 1012 | 200 | 10000 | | 1012 | 1012 | 1012 |
| | Parts by mass | 28.6 | 28.0 | 28.5 | 10.7 | 26.0 | | 27.9 | 28.5 | 28.5 |
| Chain extender (C) | C1 | | 15PD | 15PD | 15PD | 15PD | | 14BG (40 mol%) | 13PD (40 mol%) | 15PD |
| | Number average molecular weight (Mn) | | 104 | 104 | 104 | 104 | | 90 | 76 | 104 |
| | Parts by mass | | 7.4 | 1.5 | 2.2 | 2.4 | | 2.6 | 2.2 | 6.7 |
| | C2 | 14BG | | 14BG | 14BG | 14BG | 14BG | 16HD (60 mol%) | 15PD (60 mol%) | 14BG |
| | Number average molecular weight (Mn) | 90 | | 90 | 90 | 90 | 90 | 118 | 104 | 90 |
| | Parts by mass | 6.5 | | 5.2 | 7.7 | 6.6 | 5.2 | 5.0 | 4.5 | 0.6 |
| | Molar ratio "M1/(M1+M2)" | 0.00 | 1.00 | 0.20 | 0.20 | 0.24 | 0.00 | 0.00 | 1.00 | 0.91 |
| Hardness | Duro-D | 37 | 38 | 38 | 39 | 30 | 40 | 39 | 39 | 37 |
| Tensile properties | Fracture stress (MPa) | 3.9 | 5.2 | 4.4 | 1.8 | 0.8 | 7.2 | 8.2 | 3.2 | 5.4 |
| | Fracture strain (%) | 94 | 180 | 179 | 10 | 1150 | 173 | 468 | 134 | 186 |
| | Tensile product | 367 | 936 | 788 | 18 | 920 | 1246 | 3838 | 429 | 1004 |
| Workability | Flow temperature (°C) | 126 | 127 | 122 | 135 | 128 | 132 | 125 | 105 | 110 |
| | MFR | 2 | 1 | 1 | Could not be measured | 0.5 | Could not be measured | 4 | 22 | 9 |

### 5.3. Evaluation results for polyurethane

According to Tables 1 to 3, all of the polyurethanes of Examples 1 to 18 exhibited excellent mechanical characteristics (fracture stress, fracture strain, tensile product) and good workability (flow temperature, MFR).

On the other hand, it was shown that the polyurethanes of Comparative Examples 1 to 9 did not have at least one of the mechanical characteristics and workability.

Comparing the property value of Example 6 (wherein 1,4-butanediol and 1,5-propanediol were used in combination as the chain extender) with that of Comparative Example 1 (wherein only 1,4-butanediol was used as the chain extender, and the other components were similar to those of Example 6), the polyurethane of Example 6 had a durometer D hardness of 40 while the polyurethane of Comparative Example 1 had a durometer D hardness of 37. Therefore, a significant difference was not particularly observed in durometer D hardness.

While the polyurethane of Example 6 had a tensile product of 6194 MPa, the polyurethane of Comparative Example 1 had a tensile product of 367 MPa. Therefore, it was found that the polyurethane of Example 6 exhibits more excellent mechanical characteristics than the polyurethane of Comparative Example 1. While the flow temperature of the polyurethane of Example 6 was 92°C, that of the polyurethane of Comparative Example 1 was 126°C. Therefore, it was found that the polyurethane of Example 6 could be processed at a lower temperature and exhibits more excellent workability than the polyurethane of Comparative Example 1.

Furthermore, it was found that a polyurethane having a combination of an odd and even number of repeating units exhibited both mechanical characteristics and workability, whereas a polyurethane having a combination of an odd and odd number of repeating units, or a combination of an even and even number of repeating units was poor in two or more of the above five evaluation items even if the chain extenders having different chain strengths were used in combination, such as the polyurethane of Comparative Example 7 (wherein 1,4-butanediol and 1,6-heaxnediol were used in combination as the chain extender and the other components were similar to those of Example 6) and the polyurethane of Comparative Example 8 (wherein 1,3-butanediol and 1,5-propanediol were used in combination as the chain extender and the other components were similar to those of Example 6).

### 5.4. Production of chemical mechanical polishing pad

### 5.4.1. Example 19

### 5.4. la. Production of polishing layer-forming composition

100 parts by mass of the polyurethane A as the polyurethane and 34 parts by mass of beta-cyclodextrin ("Dexy Pearl beta-100" manufactured by Ensuiko Sugar Refining Co., Ltd., average particle size: 20 micrometers; hereinafter referred to as "beta-CD") as the water-soluble particles were mixed with an extruder heated to 140°C.

Then, after adding 0.5 parts by mass of dicumyl peroxide ("Percumyl D" manufactured by NOF Corporation) as a crosslinking agent to the resulting mixture, the components were further mixed at 120°C to obtain pellets of a polishing layer-forming composition.

### 5.4.1b. Production of polishing layer substrate

The polishing layer-forming composition obtained in "5.4.1a. Production of polishing layer-forming composition" was crosslinked at 180°C for 20 minutes in a press mold to obtain a cylindrical molded product (polishing layer substrate) having a diameter of 845 mm and a thickness of 3.2 mm.

### 5.4.1 c. Production of pad

The polishing layer substrate produced in "5.4.1b. Production of polishing layer substrate" was set on an insertion opening of a wide belt sander (manufactured by Meinan Machinery Works, Inc.). By moving each sandpaper (manufactured by KOVAX Corporation) with a grain size mesh of #120, #150, or #220 sequentially at the speed of 0.1 m/s, each of the front surface and the back surface of the molded product was ground by 0.1 mm per each sandpaper (the total ground amount was 0.3 mm on each of the front surface and the back surface).

Then, only the front surface (the surface to be a polishing surface) was ground by 0.1 mm by using a sandpaper of #320 in the same manner as mentioned above to obtain a pad having a diameter of 845 mm and a thickness of 2.5 mm.

### 5.4.1d. Production of chemical mechanical polishing pad

The pad produced in "5.4.1c. Production of pad" was secured on a platen of a cutting process machine (manufactured by Kato Machine Corporate) by sucking with a suction pressure of 20 kPa. While keeping this state, a group of concentric grooves having a width of 0.5 mm and a depth of 1 mm were formed at a pitch of 2 mm in an area of radius 10 mm or more from the center, and the pad was cut at a radius of 254 mm from the center with the cutting process machine to produce a chemical mechanical polishing pad with a diameter of 508 mm and a thickness of 2.5 mm.

### 5.4.2. Examples 20 to 25 and 30 to 33, Comparative Examples 9 to 13, 15, and 16

In "5.4.1a. Production of polishing layer-forming composition", chemical mechanical polishing pads of Examples 20 to 25 and 30 to 33 and Comparative Examples 9 to 13, 15, and 16 were produced in the same manner as the method of producing the chemical mechanical polishing pad of Example 19, except for changing the types of polyurethane and the amounts of water-soluble particles and crosslinking agent as shown in Tables 4 to 6.

### 5.4.3. Examples 26 to 29, Comparative Example 14

### 5.4.3a. Production of polishing layer-forming composition

Polishing layer-forming compositions were produced in the same manner in "5.4.1a. Production of polishing layer-forming composition", except for changing the types of polyurethane and the amount of water-soluble particles as shown in Tables 4 to 6.

### 5.4.3b. Production of polishing layer substrate

The polishing layer-forming composition obtained in "5.4.3a. Production of polishing layer-forming composition" was mixed with an extruder heated to 160°C to obtain pellets of a polishing layer-forming composition. Then, a mold having cavities of a diameter of 850 mm and a depth of 3.0 mm was heated to 40°C. An injection molding machine (instrument: 1600 MMIIIW, manufactured by Mitsubishi Heavy Industries Plastic Technology Co., Ltd.) wherein the cylinder temperature was set to 160°C was prepared. The resulting pellets were softened by heating in the cylinder, and they were molded by quickly inserting into the mold to obtain a cylindrical molded product (polishing layer substrate) with a diameter of 845 mm and a thickness of 3.2 mm.

### 5.4.3c. Production of pad

A pad was produced with the polishing layer substrate produced in "5.4.3b. Production of polishing layer substrate" in the same manner as in "5.4.1c. Production of pad".

### 5.4.3d. Production of chemical mechanical polishing pad

Chemical mechanical polishing pads of Examples 26 to 19 and Comparative Example 14 were produced with the pad produced in "5.4.3c. Production of pad" in the same manner as in "5.4.1d. Production of chemical mechanical polishing pad".

### 5.5. Evaluation of chemical mechanical polishing

After the surface whereon the grooves of the chemical mechanical polishing pad produced in "5.4. Production of chemical mechanical polishing pad" were not formed was laminated with a double-sided tape #422 (manufactured by 3M), the pad was installed in a chemical mechanical polishing apparatus ("Mirra" manufactured by Applied Materials, Inc.) and used for chemical mechanical polishing under the following conditions to evaluate polishing properties. The results are shown in Tables 4 to 6.
- Head rotational speed: 120 rpm
- Head load: 1.5 psi (10.3 kPa)
- Platen rotational speed: 120 rpm
- Dispersion supply rate: 200 cm³/min
- Chemical mechanical polishing aqueous dispersion: CMS 7401/CMS 7452
(manufactured by JSR Corporation)

### 5.5.1. Calculation of polishing rate

A polishing target wherein a copper film with a thickness of 15000 angstrom was formed on an eight-inch silicon substrate with a thermal oxide film was subjected to chemical mechanical polishing for one minute under the above conditions. The thickness of the copper film was measured before and after chemical mechanical polishing by using an electric conduction-type thickness meter ("OmniMap RS 75" manufactured by KLA-Tencor Corporation). A polishing rate was calculated from the thicknesses before and after chemical mechanical polishing and the polishing time. The results are shown in Tables 3 to 5. The higher the polishing rate is, the better it is. The polishing rate is preferably 800 nm/min or more, more preferably 850 nm/min or more, and particularly preferably 900 nm/min or more.

### 5.5.2. Evaluation of end point detection time and flatness

A patterned wafer ("SEMATECH 854" manufactured by SEMATECH INTERNATIONAL) was used as a polishing target. An end point detection time was obtained by measuring a period of time from the start of polishing to an end point detected by infrared rays emitted from a table. The shorter the end point detection time is, the better it is. The end point detection time is preferably 90 seconds or less, more preferably 80 seconds or less, and particularly preferably 70 seconds or less.

Flatness was evaluated by polishing a patterned wafer for a period of time that is 1.2 times the end point detection time, and measuring the amount of dishing (hereinafter may be referred to as "dishing amount") of a copper interconnect with a width of 100 micrometers in an area wherein a pattern in which a copper interconnect area with a width of 100 micrometers and an insulating area with a width of 100 micrometers were alternately provided, was continuously formed to a length of 3.0 mm in a direction perpendicular to the longitudinal direction by use of a precise step meter ("HRP-240" manufactured by KLA-Tencor Corporation). The results are shown in Tables 3 to 5. The dishing amount is preferably less than 30 nm, more preferably less than 25 nm, and particularly preferably less than 20 nm.

### 5.5.3. Evaluation of scratches

200 unit areas (120 x 120 micrometers) in a copper interconnect area on a polishing surface of a polished patterned wafer were observed at random by using a Surfscan SP 1 (manufactured by KLA-Tencor Corporation), and the number of scratches in each unit area was measured. The results are shown in Tables 3 to 5. The number of scratches is preferably less than 90, more preferably less than 70, and particularly preferably less than 50.

### 5.5.4. Evaluation of cut rate

The chemical mechanical polishing pad produced in "5.4. Production of chemical mechanical polishing pad" was installed in a chemical mechanical polishing apparatus, and the pad was dressed for one hour using A 165 (manufactured by 3M) as a dresser (table rotational speed: 60 rpm, dressing rotational speed: 65 rpm, dressing load: 4.5 kgf). In the polishing layer before and after dressing, the amount of displacement in 15 points that were spaced every 30 mm on a straight line passing through the center of the chemical mechanical polishing pad was measured by using a ultra high-accuracy laser displacement sensor ("LC-2400" manufactured by KEYENCE CORPORATION). A difference in the thickness (micrometer) of the chemical mechanical polishing pad before and after dressing was used as the amount of wear, and a value such that the amount of wear was divided by a period of time (60 minutes) of dressing was used as a cut rate (micrometer/min). The results are shown in Tables 3 to 5. A cut rate can be an index for the life of a chemical mechanical polishing pad, and it is preferably less than 3.5 micrometers/min, more preferably less than 3.0 micrometers/min, and particularly preferably less than 2.5 micrometers/min.

**TABLE 4**

| | | | Example 19 | Example 20 | Example 21 | Example 22 | Example 23 | Example 24 | Example 25 | Example 26 |
|---|---|---|---|---|---|---|---|---|---|---|
| Polishing layer-forming composition | Polyurethane | Type | A | D | E | F | F | G | H | I |
| | | Parts by mass | 100.0 | 100.0 | 100.0 | 100.0 | 100.0 | 100.0 | 100.0 | 100.0 |
| | Water-soluble particles | Type | Beta-CD | Beta-CD | Beta-CD | Beta-CD | Beta-CD | Beta-CD | Beta-CD | Beta-CD |
| | | Parts by mass | 34.0 | 34.0 | 34.0 | 34.0 | 34.0 | 34.0 | 34.0 | 2.0 |
| | Crosslinking agent | Type | Percumyl D | Percumyl D | Percumyl D | Percumyl D | Percumyl D | Percumyl D | Percumyl D | |
| | | Parts by mass | 0.5 | 0.5 | 0.5 | 0.5 | 1.5 | 0.5 | 0.5 | |
| Polishing performance | Polishing rate (nm/min) | | 804 | 810 | 860 | 978 | 995 | 810 | 850 | 800 |
| | End point detection rate (sec) | | 87 | 83 | 86 | 70 | 65 | 89 | 85 | 86 |
| | Dishing amount (nm) | | 23 | 26 | 23 | 19 | 18 | 26 | 28 | 19 |
| | Cut rate (micrometers/min) | | 3.5 | 3.3 | 3.0 | 2.5 | 2.8 | 3.1 | 3.3 | 0.5 |
| | Scratch (number) | | 82 | 78 | 50 | 21 | 29 | 39 | 57 | 35 |

**TABLE 5**

| | | | Example 27 | Example 28 | Example 29 | Example 30 | Example 31 | Example 32 | Example 33 |
|---|---|---|---|---|---|---|---|---|---|
| Polishing layer-forming composition | Polyurethane | Type | I | I | I | L | M | N | O |
| | | Parts by mass | 100.0 | 100.0 | 100.0 | 100.0 | 100.0 | 100.0 | 100.0 |
| | Water-soluble particles | Type | Beta-CD | Beta-CD | Potassium sulfate | Beta-CD | Beta-CD | Beta-CD | Beta-CD |
| | | Parts by mass | 34.0 | 95.0 | 182.0 | 34.0 | 34.0 | 34.0 | 34.0 |
| | Crosslinking agent | Type | | | | Percumyl D | Percumyl D | Percumyl D | Percumyl D |
| | | Parts by mass | | | | 0.5 | 1.5 | 0.5 | 0.5 |
| Polishing performance | Polishing rate (nm/min) | | 820 | 840 | 810 | 807 | 820 | 815 | 804 |
| | End point detection rate (sec) | | 84 | 80 | 86 | 84 | 82 | 90 | 84 |
| | Dishing amount (nm) | | 22 | 24 | 23 | 28 | 27 | 26 | 23 |
| | Cut rate (micrometers/min) | | 0.9 | 1.5 | 1.8 | 2.8 | 3.1 | 3.5 | 3.4 |
| | Scratch (number) | | 10 | 4 | 7 | 43 | 55 | 78 | 65 |

**TABLE 6**

| | | | Comparative Example 9 | Comparative Example 10 | Comparative Example 11 | Comparative Example 12 | Comparative Example 13 | Comparative Example 14 | Comparative Example 15 | Comparative Example 16 |
|---|---|---|---|---|---|---|---|---|---|---|
| Polishing layer-forming composition | Polyurethane | Type | P | P | Q | Q | R | U | V | W |
| | | Parts by mass | 100.0 | 100.0 | 100.0 | 100.0 | 100.0 | 100.0 | 100.0 | 100.0 |
| | Water-soluble particles | Type | Beta-CD | Beta-CD | Beta-CD | Beta-CD | Beta-CD | Beta-CD | Beta-CD | Beta-CD |
| | | Parts by mass | 34.0 | 34.0 | 34.0 | 34.0 | 34.0 | 34.0 | 34.0 | 34.0 |
| | Crosslinking agent | Type | Percumyl D | Percumyl D | Percumyl D | Percumyl D | Percumyl D | | Percumyt D | Percumyl D |
| | | Parts by mass | 0.5 | 1.5 | 0.5 | 1.5 | 0.5 | | 0.5 | 0.5 |
| Polishing performance | Polishing rate (nm/min) | | 764 | 950 | 690 | 784 | 824 | 830 | 806 | 680 |
| | End point detection rate (sec) | | 86 | 70 | 96 | 84 | 85 | 82 | 82 | 99 |
| | Dishing amount (nm) | | 25 | 18 | 33 | 29 | 13 | 45 | 24 | 42 |
| | Cut rate (micrometers/min) | | 3.7 | 5.4 | 3.2 | 4.2 | 4.7 | 1.2 | 4.2 | 3.8 |
| | Scratch (number) | | 94 | 167 | 115 | 148 | 136 | 124 | 153 | 57 |

### 5.6. Evaluation results for chemical mechanical polishing pad

As shown in Tables 4 and 5, the chemical mechanical polishing pads of Examples 19 to 33 achieved good results for the polishing rate, the end point detection rate, the dishing amount (flatness), the cut rate, and scratches.

In contrast, the chemical mechanical polishing pads of Comparative Examples 9 to 16 had poor results for two or more items.

As is clear from the above results, the thermoplastic polyurethane composition according to the invention exhibits excellent mechanical characteristics and good workability. A chemical mechanical polishing pad that exhibits an excellent polishing rate, end point detection rate, flatness, and scratch resistance, and has a polishing layer having a long life can be obtained by utilizing the composition as a polishing layer-forming composition.

### REFERENCE SIGNS LIST

10: polishing layer, 12: support layer, 14: platen of polishing apparatus, 16, 17, 18, 19: grooves, 20: polishing surface, 24: side surface, 100, 200, 300: chemical mechanical polishing pad

## Claims

1. A polyurethane produced by reacting a mixture comprising at least (A) a diisocyanate, (B) a polyol, and (C) a chain extender, the polyol (B) having a number average molecular weight of 400 to 5000, the chain extender (C) including (C1) a compound shown by a general formula (1) and (C2) a compound shown by a general formula (2), the compound (C1) and the compound (C2) having a number average molecular weight of less than 400, and a ratio "M₁/(M₁+M₂)" calculated by using a number of moles (M₁) of the compound (C1) and a number of moles (M₂) of the compound (C2) being 0.25 to 0.9,
HO-(CR¹R²)₂ₘ₊₁-OH (1)
wherein R¹ and R² individually represent a hydrogen atom or a substituted or unsubstituted alkyl group having 1 to 6 carbon atoms, and m is an arbitrary integer from 1 to 13,
HO-(CR³R⁴)₂ₙ-OH (2)
wherein R³ and R⁴ individually represent a hydrogen atom or a substituted or unsubstituted alkyl group having 1 to 6 carbon atoms, and n is an arbitrary integer from 1 to 12.

2. The polyurethane according to claim 1,
wherein R¹ and R² are hydrogen atoms.

3. The polyurethane according to claim 1 or 2,
wherein the compound (C1) is at least one compound selected from 1,3-propanediol and 1,5-pentanediol.

4. The polyurethane according to any one of claims 1 to 3,
wherein R³ and R⁴ are hydrogen atoms.

5. The polyurethane according to any one of claims 1 to 4,
wherein the compound (C2) is at least one compound selected from ethylene glycol, 1,4-butanediol, 1,6-hexanediol, and 1,18-octadecanediol.

6. A polishing layer-forming composition comprising at least water-soluble particles and the polyurethane according to any one of claims 1 to 5.

7. The polishing layer-forming composition according to claim 6, further comprising a crosslinking agent.

8. A chemical mechanical polishing pad produced by using the polishing layer-forming composition according to claim 6 or 7.

9. A chemical mechanical polishing method comprising chemically and mechanically polishing a polishing target by using the chemical mechanical polishing pad according to claim 8.
